# EUROPEAN PATENT APPLICATION

(11) **EP 2 506 691 A1**
(43) Date of publication of application: **03.10.2012**
(21) Application number: 11464015.4
(22) Date of filing: 12.10.2011
(51) Int. Cl.: H05K 5/00, B60R 16/023

(54) **Housing for control units**

(71) Applicant: Continental Automotive GmbH, 30165 Hannover (DE)
(72) Inventor: Birdeanu, Mircea, 300481 Timisoara (RO)

(57) **Abstract**

The invention comprises a housing (1, 11, 21) for control units for automotive applications, comprising
- at least two sides (2, 3, 12, 13, 14, 22, 23, 24),
- at least one bended part (8a, ..., 8f),
- wherein the at least one bended part (8a, ..., 8f) connects the at least two sides (2, 3, 12, 13, 14, 22, 23, 24),
so that the housing (1, 11, 21) is at least partially form-closed with regard to the at least one bended part (8a, ..., 8f) and an equipment (7, 17, 27) the housing (1, 11, 21) is mounted on..

## Description

The invention relates to a housing for control units.

In automobiles the available space for electrical or mechanical units is decreasing and reaching its limits. This is dedicated to an increasing number of primarily electronic units. For car manufacturers this problem fits in to the general challenge of optimizing the usage of the available space for a given number of functionalities and performance requirements. However, additional functionalities require additional space for further electrical units, their housings and mounting capabilities. In particular, housings are required for protecting devices and their electrical circuits with regard to electromagnetic disturbances, mechanical distortions or dirt from the outside. A commonly used shape of housings is box-like. That shape is not optimized in size.

The object of the invention is to create a housing with an optimized size in order to use the available space in the car more efficiently.

This object is achieved by a housing with the features of claim 1. Advantageous embodiments which can be used individually or in combination are the subject matter of the dependent claims.

The housing for control units for automotive applications according to the invention comprises
- at least two sides,
- at least one bended part,
- wherein the at least one bended part connects the at least two sides,
so that the housing is at least partially form-closed with regard to the at least one bended part and an equipment the housing is mounted on. The equipment with the mounted housing requires overall less space which can be used for other components.

In a preferred embodiment the at least one bended part comprises an angle of 90° for fitting to an edge which is adjusted between two sides of the equipment. An angle of 90° at the housing is easy to manufacture as it is a common mechanical shape.

In another preferred embodiment the housing comprises two bended parts with two angles. Those bended parts can be aligned in the same direction or in different directions. If the bended parts are aligned in the same direction the housing comprises a U-shape. A favorable U-shape is formed if both angles are 90°. Such a housing can preferably mounted on an advance of an equipment where the U-shape of the housing is fitting to.

In another preferred embodiment the housing comprises a corner-shape. That means the housing is formed by three sides which are assembled at 90°-angles to each other. That corner shape of the housing can fit to a corner of an equipment. For example a rectangular block comprises eight corners where that housing shape would fit to.

In another preferred embodiment the housing comprises at least one circuit board which is aligned to the shape of the housing. This has the advantage that the cooling of the circuit board is maintained throughout the part of the circuit board which is aligned with the housing.

In another preferred embodiment the circuit board comprises at least one flexible part so that it can fit to the bended housing. The circuit board can be adjusted even better to the geometrical requirements of the equipment, and is not bound to one shape of one housing, but can be implemented also in another housing.

A further advantage is that by adjusting the shape of the circuit board to the housing

Further advantages and embodiments of the invention will be explained below on the basis of an exemplary embodiment shown in the drawings.

The figures show the following schematic diagrams:
Figure 1 a housing with one bend;
Figure 2 a housing with two bends; and
Figure 3 a corner-shaped housing.

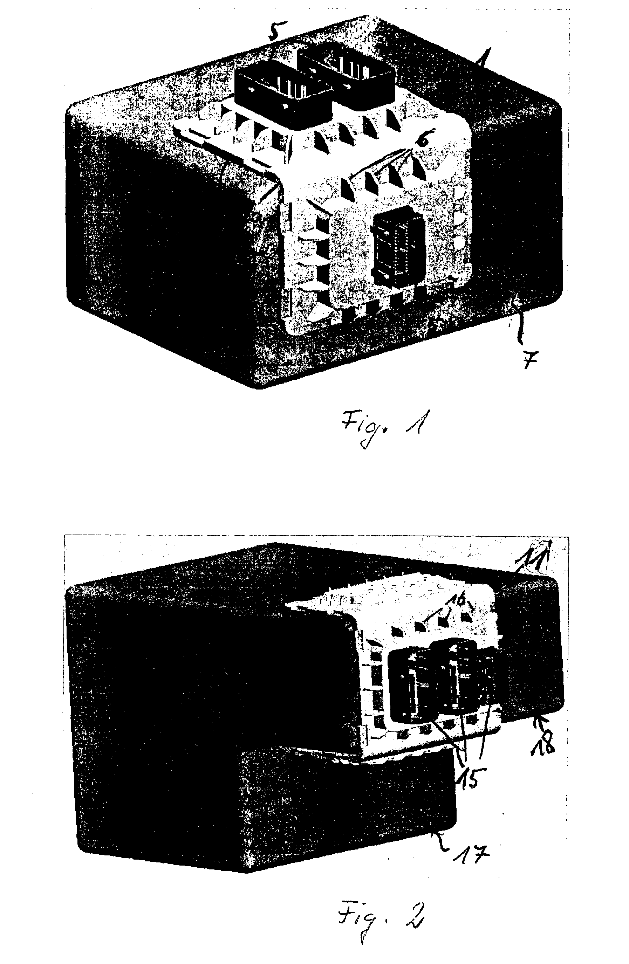

Figure 1 shows a perspective view of a housing 1 with sides 2, 3. The housing 1 comprises also cooling fins 6 and electrical plug-ins or connectors 5. The sides 2, 3 are connected by a bended part 8a so that the housing 1 is form-closed with regard to the bended part 8a and equipment 7 the housing 1 is mounted on. The angle at the bend comprises 90° which leads to an L-shape of the housing 1. The equipment 7 is a rectangular block with rectangular edges. In the mounting position of the housing 1 at the equipment 7 the sides 2, 3 fit form-closed to the surfaces of the equipment 7. This is because both the housing 1 and the equipment 7 have the same angle between the corresponding surfaces.

Figure 2 shows a housing 11 with three sides 12, 13, 14. The housing comprises further cooling fins 16 and electrical plug-ins or connectors 15. The sides 12 and 14 are parallel to each other and side 13 is rectangular both to side 12 and side 14. That means the housing 1 comprises two bended parts 8b, 8c with a rectangular angle which leads overall to a U-shape of the housing 11. The equipment 17 comprises a rectangular block with an advance 18, which is also a rectangular block. Due to the U-shape the housing 11 fits form-closed to the advance 18.

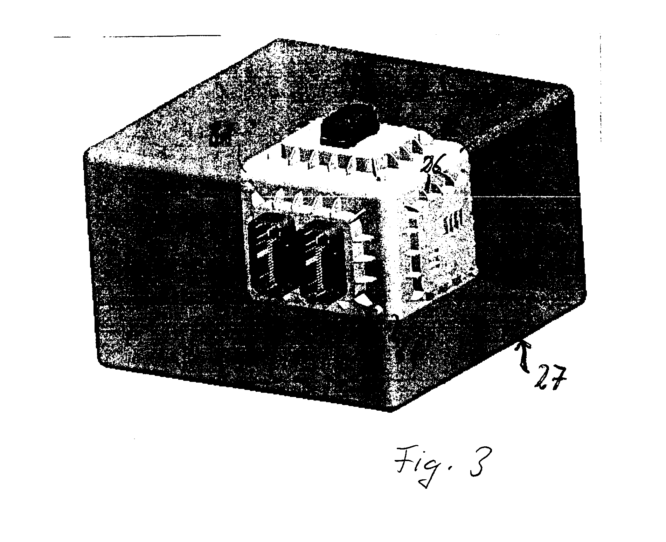

Figure 3 shows a housing 21 with three sides 22, 23, 24. The housing further comprises cooling fins 26 and electrical plug-ins or connectors 25. The sides 22, 23 and 24 are rectangular to each other so that the housing 21 forms a corner shaped body. That means the housing 21 comprises three bended parts 8d, 8e, 8f, each comprising a rectangular angle. The equipment 27 comprises a rectangular block with rectangular edges. The housing 21 can be mounted form-closed to an edge of the equipment 27.

The housing 1, 11, 21 and the corresponding equipment 7, 17, 27 can be also of any other shape. For example the housing 1, 11, 21 can have sides 2, 3, 4, 12, 13, 14, 22, 23, 24 with a circular or curved shape. Also, the shape of the complete housing 1, 11, 21 can comprise a circular or curved shape. Furthermore, the angle of the bend can be different to 90°.

The housing 1, 11 with an L- or U-shape can be made by bending the piece of material at two lines until the required shape is achieved. The housing with the three sides can also be manufactured in one piece, for example as die-cast. The three sides can be also joined by soldering, welding or gluing.

The invention of a form-closed housing 1, 11, 21 can be advantageously applied to equipments 7, 17, 27 assembled in automobiles for saving space and using the available space more efficiently. Also, if circuit boards are mounted inside the housing 1, 11, 21 an entire electrical unit can benefit from the efficient use of the available space.

## Claims

1. Housing (1, 11, 21) for control units for automotive applications, comprising
- at least two sides (2, 3, 12, 13, 14, 22, 23, 24),
- at least one bended part (8a, ..., 8f),
- wherein the at least one bended part (8a, ..., 8f) connects the at least two sides (2, 3, 12, 13, 14, 22, 23, 24),
so that the housing (1, 11, 21) is at least partially form-closed with regard to the at least one bended part (8a, ..., 8f) and an equipment (7, 17, 27) the housing (1, 11, 21) is mounted on.

2. Housing (1, 11, 21) according to claim 1, wherein the at least one bended part (8a, ..., 8f) comprises an angle of 90°.

3. Housing (1, 11, 21) according to claim 1, comprising two bended parts (8a, ..., 8f) with two angles.

4. Housing (1, 11, 21) according to claim 3, wherein the two bended parts (8a, ..., 8f) comprise each an angle of 90°.

5. Housing (1, 11, 21) according to claim 1 or 4, comprising a corner-shape.

6. Housing (1, 11, 21) according to claim 1 to 5, comprising at least one circuit board which is aligned to the shape of the housing (1, 11, 12).

7. Housing (1, 11, 21) according to claim 6, wherein the circuit board comprises at least one flexible part.

8. Housing (1, 11, 21) according to claim 7, wherein the circuit board is bended at the flexible part in order to fit the housing (1, 11, 21) form-closed.
